(19) Europäisches Patentamt
European Patent Office
Office européen des brevets

(11) **EP 4 654 243 A1**

(12) # EUROPEAN PATENT APPLICATION

(43) Date of publication:
**26.11.2025 Bulletin 2025/48**

(21) Application number: **25168624.2**

(22) Date of filing: **04.04.2025**

(51) International Patent Classification (IPC):
**H01J 37/20** *(2006.01)* **H01J 37/28** *(2006.01)*
**F25B 21/02** *(2006.01)*

(52) Cooperative Patent Classification (CPC):
**H01J 37/20; F25B 21/02; H01J 37/28;**
H01J 2237/2001; H01J 2237/202

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **20.05.2024 JP 2024081542**

(71) Applicant: HITACHI HIGH-TECH CORPORATION
Tokyo 105-6409 (JP)

(72) Inventors:
• **NISHIOKA, Akira**
**Tokyo, 100-8280 (JP)**
• **YAMAMOTO, Raifu**
**Tokyo, 105-6409 (JP)**
• **ANDO, Yasuhiro**
**Tokyo, 105-6409 (JP)**

(74) Representative: **Mewburn Ellis LLP**
**Aurora Building**
**Counterslip**
**Bristol BS1 6BX (GB)**

(54) **STAGE DEVICE AND CHARGED PARTICLE BEAM DEVICE EQUIPPED WITH THE SAME**

(57) An object is to provide a stage device capable of preventing thermal deformation of a stage and improving positioning accuracy in positioning the stage even in a method in which a Peltier element is arranged on a stage on the stationary side, and a charged particle beam device including the stage device.

Provided are a stage device having a first stage that moves linearly, a first fin having a comb-like cross-sectional shape and extending in the linear movement direction of the first stage, a second stage having a second fin disposed opposite the first fin and being stationary in relation to the first stage, a heat transfer mechanism that transfers heat between the first fin and the second fin while maintaining a non-contact relation therebetween, a Peltier module between the second fin and the second stage with one heat transfer surface of the Peltier module in contact with the second fin and the other heat transfer surface in contact with the second stage, and a control unit to control the temperature of the second fin by the Peltier module, and a charged particle beam device including the stage device.

FIG. 1

EP 4 654 243 A1

**Description**

BACKGROUND OF THE INVENTION

1. Field of the Invention

The present invention relates to a stage device and a charged particle beam device equipped with the same.

2. Description of the Related Art

The integration degree of semiconductor products is increasing year by year, and their circuit patterns are becoming finer year by year. Various kinds of inspection means are used on semiconductor wafers on which circuit patterns are formed, for the purposes of quality control and yield enhancement. As one kind of the means, there is known a technique in which a scanning electron microscope is used to capture an image of a semiconductor wafer and inspect the circuit pattern from the obtained image.

In such a sample as a semiconductor wafer, circuit patterns are formed at high density, and hence, a particularly high degree of positional accuracy is required in a stage device for a scanning electron microscope.

One method for improving the positional accuracy of a stage device is to use a levitation stage to prevent vibration propagation and to prevent positional errors caused by vibrations. However, since stage devices for scanning electron microscopes are used in a vacuum, using a levitation stage makes it difficult to dissipate heat from the stage. If the stage cannot dissipate heat, the heat generated inside the stage will change the stage temperature, and the resulting thermal deformation will deteriorate the positioning accuracy. Hence, JP-2003-058258-A discloses a technique for improving positional accuracy by actively cooling the levitation stage. JP-2003-058258-A discloses a technology for suppressing thermal deformation of the stage by creating a blackbody surface for a magnetic levitation stage in a vacuum, placing a radiation plate in a non-contact state on the blackbody surface, and cooling the rear side of the radiation plate by using a Peltier element, and further cooling the opposite surface of the Peltier element with a cooling plate, in order to improve positional accuracy by suppressing temperature rise of the stage and preventing thermal deformation. Furthermore, JP-2003-058258-A discloses another embodiment in which Peltier elements are placed above a magnetic levitation stage to be divided and arranged on a plane and the Peltier elements are driven according to the planar position of the stage to provide effective cooling.

Meanwhile, radiation heat transfer (= radiant heat transfer) typically has weaker thermal conductivity than thermal conduction through solids, and when there is the same temperature difference, radiation heat transfer is more likely to result in a smaller heat flux than thermal conduction through solids. JP-2006-351741-A is one means of solving this problem. In JP-2006-351741-A, in order to increase the surface area for radiant heat transfer, fins whose cross sections have comb-like shapes are arranged facing each other, and radiant heat transfer is performed between the two fins, thereby increasing the heat transfer area per unit space. Moreover, because the fins extend in the direction in which the stage moves, the fins do not interfere with each other even when the stage moves. Further, JP-2006-351741-A also indicates that a Peltier element is placed on the stage that moves relative to the stationary side. If a Peltier element is placed on the stationary side opposed to the moving stage, the relative positional relation between the Peltier element and the moving stage constantly changes, but if a Peltier element is placed on the moving stage, the relative positional relation is fixed and maintained. This means that the relative position of the Peltier element does not change no matter how much the stage moves around, which is a great advantage in controlling the temperature of the stage.

SUMMARY OF THE INVENTION

When a Peltier element is placed on the moving stage side, as in JP-2006-351741-A, the amount of heat equivalent to the power required to operate the Peltier element also needs to be transferred to the stationary side by radiant heat transfer. On the other hand, when the Peltier element is placed on the stationary side, as in JP-2003-058258-A, there is no need to make radiant heat transfer for the amount of heat equivalent to electric power consumed by the Peltier element. Hence, the method of arranging the Peltier element on the moving stage side has the disadvantage that the load of radiant heat transfer is larger than that in the method of arranging the Peltier element on the stationary side.

Moreover, when a Peltier element is placed on the stationary side as in JP-2003-058258-A and comb-shaped fins are used while facing each other as in JP-2006-351741-A, there arises such a problem that it becomes difficult to appropriately control the stage temperature due to the time delay that occurs when the temperature of the fins changes.

In a typical device, the time taken for the stage to move to the next place after staying in one place is not very long. When a Peltier element is disposed on the stationary side and the stage moves, the control system must respond such that the Peltier element disposed at the new location cools the stage. However, when the Peltier element cools the fins and increases the temperature difference between opposing fins to thereby increase radiant heat transfer and cool the stage, a time delay occurs between the time when the Peltier element increases the amount of heat absorption and the time when the temperature of the cooled fin drops, according to the thermal capacity of the fin. Therefore, even if an attempt to cool the stage is made by increasing the amount of heat absorbed by the Peltier element and lowering the fin temperature after the stage has moved to a location, the stage would be moved to the next location by the time when the fin temperature has dropped to a level enough to cool the stage, resulting in the problem that the stage cannot be cooled properly. This problem does not arise when the Peltier element is placed on the moving stage side as in JP-2006-351741-A, because the Peltier element follows the stage movement. However, this configuration has the problem that the load of radiant heat transfer is greater than in a method in which the Peltier element is placed on the stationary side.

When the heat absorption surface of the Peltier element is used as the radiant heat transfer surface without fins being used as in JP-2003-058258-A, since the amount of heat absorbed from the stage changes instantly when the current in the Peltier element is changed, the above-mentioned delay does not pose a problem, but at the time of using a method in which the Peltier element is placed on the stationary side and a comb-shaped fin is used, a unique problem that it is difficult to control the temperature of the stage arises because the time delay in the temperature control system is large compared to the time interval to move the stage from one location to another.

An object of the present invention is to provide a stage device that can reduce the load on cooling the stage due to radiant heat transfer to obtain more efficiency, prevent thermal deformation by preventing changes in the stage temperature over time, and improve the positioning accuracy of the stage, and to provide a charged particle beam device including the stage device.

In order to achieve the above object, the present invention is configured as follows.

A stage device includes a first stage that moves linearly, a first fin having a comb-like cross-sectional shape and extending in a linear movement direction of the first stage, a second stage that has a second fin disposed opposite the first fin and is stationary in relation to the first stage, and a heat transfer mechanism that transfers heat between the first fin and the second fin while maintaining a non-contact relation therebetween, a Peltier module is provided between the second fin and the second stage with one heat transfer surface of the Peltier module in contact with the second fin and the other heat transfer surface in contact with the second stage, and a control unit that controls the heat transfer that occurs between the first fin on the first stage side and the second fin by controlling the temperature of the second fin by using the Peltier module is provided. Furthermore, a plurality of Peltier modules are placed on the second stage in a direction of movement of the first stage as the Peltier module, the plurality of Peltier modules are controlled to equalize the temperature of the second fin, and thus, the second fin can receive uniform heat transfer wherever the first stage moves. In addition, a charged particle beam device that includes the stage device is configured.

By placing a Peltier element on the stage on the stationary side, the load of radiant heat transfer is reduced, and the heat-transfer capability is improved by increasing the surface area by use of fins. Further, there can be provided a stage device which solves the problem of delays in temperature control caused by the thermal capacity of the fins, and thus prevents the stage temperature from changing over time, to thereby prevent thermal deformation of the stage and improve the positioning accuracy of the stage, and in addition, a charged particle beam device including the stage device can also be provided.

BRIEF DESCRIPTION OF THE DRAWINGS

FIG. 1 is a diagram of a stage device of a first embodiment viewed in a direction of movement of a levitation stage;
FIG. 2 is a diagram of the stage device of the first embodiment viewed perpendicularly to the direction of movement of the levitation stage;
FIG. 3 is a diagram of a stage device and a system according to a second embodiment;
FIG. 4 is a diagram of a stage device and a system according to a third embodiment;
FIG. 5 is a diagram of a stage device and a system according to a fourth embodiment;
FIG. 6 is a diagram of a stage device and a system according to a fifth embodiment;
FIG. 7 is a diagram of a stage device and a system according to a sixth embodiment; and
FIG. 8 is a diagram of a stage device and a system according to a seventh embodiment.

DESCRIPTION OF THE PREFERRED EMBODIMENTS

Hereinafter, embodiments of the present invention will be described with reference to the drawings.

[First embodiment]

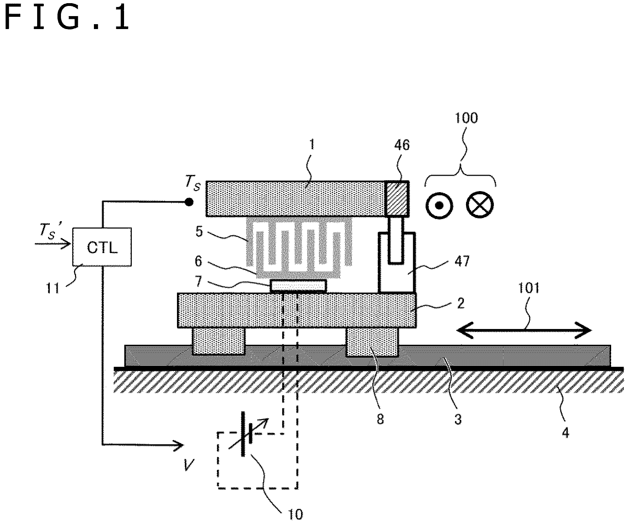

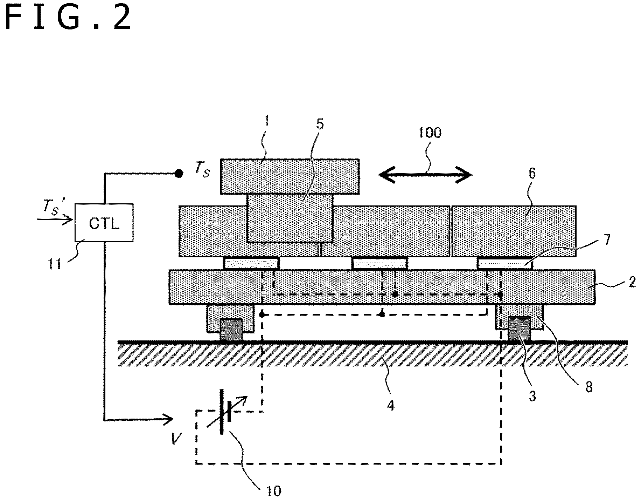

A configuration and a system of a stage device in a first embodiment of the present invention are illustrated in FIGS. 1 and 2. FIGS. 1 and 2 illustrate the same device, but are viewed from angles different from each other by 90°.

In this stage device, an upper stage 1 is a levitation stage, and a lower stage 2 is a guide rail type stage. In FIG. 1, the upper stage 1 (also called the "levitation stage" or "first stage") moves in the depth direction on the page, and the direction of movement is indicated by an arrow 100. Further, the lower stage 2 (also referred to as the "second stage") moves in the direction of an arrow 101. In FIG. 2, the upper stage 1 moves in the direction indicated by the arrow 100, and the lower stage 2 moves in the depth direction on the page.

The upper stage 1 is driven by a linear motor for the upper stage, which includes a coil component 46, which is a mover, and a magnet component 47, which is a stator. Thrust force is generated when a current is passed through the coil component 46 in the magnetic field formed by the magnet component 47, and this thrust force is transmitted to the upper stage 1, causing the upper stage 1 to move in the direction of the arrow 100. When such a drive of the stage is carried out, heat is generated by the current flowing through the coil component. In other words, a coil always has electrical resistance, and Joule heat is generated in proportion to the product of the electrical resistance and the square of the current flowing through the coil. The coil component 46 needs to transmit thrust to the upper stage 1, and hence, the two components must be connected to each other. Joule heat from the coil component 46 is transmitted to the upper stage 1, and raises the temperature of the upper stage 1. Note that, in FIGS. 1 and 2, illustrations of a mechanism for levitating the upper stage 1, a mechanism for measuring the stage position, a mechanism for driving the lower stage 2, etc. are omitted.

As illustrated in FIG. 1, a heat dissipation fin 5 (also called a "first fin") is attached to the bottom surface of the levitation stage 1. The heat dissipation fin 5 has a comb-shaped cross section and extends in the depth direction of the levitation stage 1 while maintaining the same cross-sectional shape. A heat absorption fin 6 (also called a "second fin") described below also has a similar comb-like cross-sectional shape. The tips of the teeth of the two fins are made to face each other, and the teeth of each fin are so arranged as to fit into the gaps of the other fin. By arranging the fins in this way, most of the surface areas of the two fins face each other.

Thermal radiation proportional to the fourth power of the absolute temperature is caused on a surface of a solid, and when exposed to thermal radiation, an object has the property of absorbing or reflecting the energy of the thermal radiation. The rate at which a solid surface absorbs radiant heat is called emissivity, and this emissivity is the same as the rate at which actual thermal radiation occurs compared to the amount of heat radiated by a blackbody surface. It is hence desirable for the heat dissipation fin 5 and heat absorption fin 6 to have high surface emissivity. In the heat dissipation fin 5, heat is released from the fin surface, so that the temperature decreases from the base to the tip of the comb teeth. Accordingly, it is preferable to use a material with high thermal conductivity for the fin. Moreover, regarding a stage that moves repeatedly, as the mass of the component becomes lighter, the inertial force becomes smaller, which leads to reduced vibration. For this reason, the density (specific gravity) of the fin material is preferably lower. Aluminum is a material with high thermal conductivity and low density, and A6063 and A6061 in particular are suitable for use as fin materials. Meanwhile, since aluminum typically has low emissivity, when fin is formed from aluminum, it is preferable to carry out surface treatment to increase the emissivity. In addition, it is common practice to modify the surface of aluminum material by alumite treatment to enhance corrosion resistance. It is even better to apply special alumite treatment which can improve emissivity to both the heat dissipation fin and the heat absorption fin.

The heat absorption fin 6 is connected to the lower stage 2 via a Peltier module 7 (sandwiched therebetween). It is preferable to have the heat absorption fin 6 which is not in direct contact with the lower stage 2, to allow the temperature of the heat absorption fin 6 to be more precisely controlled by the Peltier module 7 (also referred to as the "first Peltier module"). The Peltier module 7 typically has a number of Peltier elements arranged on an electrically insulating plate, these elements are connected by an electrical circuit, and further both the top and bottom surfaces are constituted by insulating plates, so that one of the top and bottom surfaces serves as a heat absorption surface and the other serves as a heat dissipation surface.

In the present embodiment, the upper surface of the Peltier module 7 is a heat absorption surface, which cools the heat absorption fin 6. In addition, the lower surface of the Peltier module 7 is a heat dissipation surface, and by bringing this surface into contact with the lower stage 2, the exhaust heat of the Peltier module 7 is transferred to the lower stage 2. The law of conservation of energy always holds true also when the Peltier module 7 is operated. Hence, the amount of dissipated heat is the sum of the amount of heat absorbed by the Peltier module 7 and the power consumption (= supplied power). Accordingly, heat cannot be absorbed unless heat is dissipated. Hence, cooling the heat absorption fin 6 with use of the Peltier module 7 can only be achieved by dissipating heat to the lower stage 2. The lower stage 2 passes the heat received from the Peltier module 7 to a guide rail 3 via a slide unit 8, and the heat is transmitted to a base 4 of the stage device. When this stage device is inside a vacuum vessel, the base 4 will be the vacuum vessel in many cases.

In order for the heat absorption fin 6 to efficiently cool the levitation stage 1, it is preferable that the heat absorption fin 6 absorb only the radiant heat transferred from the heat dissipation fin 5 and is not affected by heat transferred from other sources. As means for achieving this, it is advisable to have both end fins of the heat absorption fin 6 be covered by the heat dissipation fins 5 (for example, in the configuration of FIG. 1, the number of fins of the heat dissipation fin 5 is set to be one more than the number of fins of the heat absorption fin 6). In this way, the heat absorption fin 6 can be prevented from absorbing heat from other sources and placing an unnecessary load on the Peltier module 7.

In addition, the back side of the base of the teeth of the comb-shaped heat absorption fin 6 faces the lower stage 2. It is better for the heat absorption fin 6 not to receive radiant heat from the lower stage 2, either and it is better for the back side of the heat absorption fin 6 to have low emissivity.

When the heat absorption fin 6 is made of aluminum, it is preferable to perform surface treatment to improve the emissivity only on the front surface of the fin, and to leave the rear surface of the fin exposed as aluminum material to keep high reflectivity. Also, in the structure for fixing both the heat absorption fin 6 and the Peltier module 7 to the lower stage 2, it is preferable to adopt a configuration that suppresses heat conduction.

It is preferable to attach the heat absorption fin 6 by pressing the fin against the lower stage 2 with bolts while sandwiching the Peltier module 7 therebetween, because this applies pressure to the heat transfer surface. However, if the bolts have a high thermal conductivity, heat will flow from the lower stage 2 toward the low-temperature heat absorption fin 6, and thus increases the cooling load on the Peltier module 7 accordingly. Hence, it is preferable to use a material with low thermal conductivity, such as resin, for the bolts that attach the heat absorption fin 6 to the lower stage 2 with the Peltier module 7 therebetween.

In order to keep the temperature of the levitation stage 1 constant at the target temperature, it is advisable to send a command to a power supply unit 10 that supplies a current to the Peltier module 7 while the temperature is measured with a temperature measuring unit (not illustrated), and to thereby perform feedback control for the cooling capacity of the Peltier module 7. When the measured temperature of the levitation stage 1 is denoted as Ts and the target temperature as Ts' and Ts > Ts' holds, the current flowing through the Peltier module 7 is increased to enhance the cooling capacity. Conversely, when Ts < Ts' holds, the current flowing through the Peltier module 7 is reduced to lower the cooling capacity. To further improve this control operation, it is advisable to introduce proportional-integral-differential (PID) control. In other words, this method uses three variables, namely, the value of Ts - Ts', the time differential value of that value, and the time integral value of that value, and determines the current to be passed through the Peltier module 7, according to the result obtained by adding up the three variables after setting a proportionality coefficient (= weighting) for each of the three variables.

Alternatively, there may be used a control method that takes into account the delay time that occurs between the change in the temperature of the heat absorption fin 6 after the change in the current flowing through the Peltier module 7 and change in the temperatures of the heat dissipation fin 5 and the main body of the levitation stage 1. These control operations are performed by a controller 11 (also called a "control unit").

As illustrated in FIG. 2, when the movement of the levitation stage 1 is viewed from the side, three Peltier modules 7 are arranged in the direction of movement of the levitation stage 1 in the present embodiment. The arrangement of three here is just one example, and the number can be changed as necessary. In order for the levitation stage 1 to move around, a range of movement larger than the size of the main body of the levitation stage 1 is set, and in order to exert cooling capacity anywhere within that range, it is advisable to arrange a plurality of Peltier modules in a line in the direction of the stage movement.

Thus, when using a plurality of Peltier modules, in the present embodiment, the electrical circuit for supplying current is configured as a parallel circuit, and the same voltage (V) is applied to all Peltier modules. The purpose of applying the same voltage is to make the temperature of the heat absorption fin 6 uniform in the direction of movement of the levitation stage 1. Note that, although FIG. 2 illustrates the heat absorption fin 6 having been divided for each Peltier module 7, the heat absorption fin 6 may be manufactured as a single unit.

Manufacturing the heat absorption fin 6 as a single unit has the advantage that the overall temperature is uniform owing to thermal conduction of the solid. Meanwhile, when the temperature of the heat absorption fin is specifically lowered, the temperature difference from the other parts will be large, and only the heat absorption fin will experience large thermal contraction, which generates thermal stress. If the heat absorption fin 6 is divided for each Peltier module 7, there is an advantage that this thermal stress is reduced.

As illustrated in FIG. 2, when the levitation stage 1 stays biasedly toward the left side within its range of movement for a long period of time, heat is mainly exchanged with the heat absorption fins 6 on the left side. In other words, the heat generated in the levitation stage 1 is transferred to the heat absorption fin 6 via the heat dissipation fin 5, but since this radiant heat transfer mainly occurs at the position where the surfaces of the fins face each other, the heat absorption fin 6 is subjected to a thermal load only at the position where the heat dissipation fin 5 is located. Even so, if the temperature of the levitation stage 1 is measured and the cooling capacity of the Peltier module 7 is controlled through feedback, the levitation stage 1 can be brought to the target temperature. However, this is the case when the levitation stage 1 stays in the same place all the time, and if it is assumed that the levitation stage 1 moves around, the situation will be changed.

When the levitation stage 1 stays biasedly toward the left side in its range of movement for a long period of time and a plurality of Peltier modules 7 are operated with the same cooling capacity, the levitation stage 1 will be maintained at the target temperature, but the heat absorption fin 6 in areas where the levitation stage 1 is not present will not be subjected to thermal load and will become overcooled. In other words, the heat absorption fin 6 on the right side of FIG. 2 will be at a lower temperature than on the left side. Even so, this is fine when the levitation stage 1 does not come to the right side, but if it suddenly comes to the right side, the levitation stage 1 will be cooled too much. If it is detected that the levitation stage 1 is overcooled, the cooling capacity of the Peltier module 7 can be reduced, but this will cause a time delay, and a temporary drop in the temperature of the levitation stage 1 will be unavoidable. This can be prevented by supplying current to a plurality of Peltier modules 7 in a parallel circuit, as illustrated in FIG. 2.

The principle behind the above is explained with use of the equations for the operating characteristics of the Peltier module. The variables used in the equations are as illustrated in Table 1.

[Table 1]

**Table 1**

**List of variables for the equations indicating operating characteristics of the Peltier module**

| $Q_C$ | Amount of heat absorption [W] |
|---|---|
| $Q_H$ | Amount of heat dissipation [W] |
| $T_C$ | Absolute temperature of the heat absorption surface [K] |
| $T_H$ | Absolute temperature of the heat dissipation surface [K] |
| ? ? | Temperature difference between the heat absorption surface and the heat dissipation surface [K] |
| $I$ | Current [A] |
| $V$ | Voltage [V] |
| $V_Z$ | Thermoelectromotive force [V] |
| $P$ | Supplied power [W] |
| ? | Seebeck coefficient [V/K] |
| $K$ | Heat conduction coefficient [W/K] |
| $R$ | Electrical resistance [Ω] |

First, equation (1) represents the amount of heat absorbed [W] by the Peltier module.
[Math. 1]

$$Q_C = \alpha T_C\, I - K\, \Delta T - \frac{1}{2} I^2 R \qquad \cdots\ (1)$$

The heat absorption effect of a Peltier module occurs in proportion to the current passed therethrough, and the proportionality coefficient can be expressed by use of the Seebeck coefficient and the absolute temperature of the heat absorption surface. Meanwhile, the temperature difference generated between the heat dissipation surface and the heat absorption surface of the Peltier module and expressed by equation (3) causes thermal conduction and reduces the amount of heat absorbed by the Peltier module.
[Math. 2]

$$Q_H = \alpha T_H\, I - K\, \Delta T + \frac{1}{2} I^2 R \qquad \cdots\ (2)$$

In addition, the electrical resistance of the Peltier module generates Joule heat according to the current passed therethrough, and half of that heat flows to the heat absorption surface and half to the heat dissipation surface. Meanwhile, the first term on the right side of equation (2) regarding the amount of heat dissipation from the Peltier module indicates the effect of current, and its proportionality coefficient is determined by the Seebeck coefficient and the absolute temperature of the heat dissipation surface.
[Math. 3]

$$\Delta T = T_H - T_C \qquad \cdots\ (3)$$

The difference in the coefficient for current between the amount of heat absorption and the amount of heat dissipation comes from the Seebeck effect. This Seebeck effect can be described by equation (4), and is a phenomenon in which thermoelectromotive force is generated in proportion to the temperature difference between the heat dissipation surface and the heat absorption surface.

[Math. 4]

$$V_Z = \alpha \, \Delta T \qquad \cdot \cdot \cdot \ (4)$$

Due to this Seebeck effect, the voltage across the Peltier module is expressed as equation (5).

[Math. 5]

$$V = IR + \alpha \, \Delta T \qquad \cdot \cdot \cdot \ (5)$$

In other words, the sum of the voltage generated by the product of the current and the electrical resistance and the thermoelectromotive force caused by the Seebeck effect becomes the voltage when a current is passed through the Peltier module. Incidentally, the electric power (= power consumption) supplied to a Peltier module is the same as that of a normal direct current (DC) load and can be calculated by multiplying the voltage by the current. In addition, the law of conservation of energy, which states that the difference between the amount of heat dissipated and the amount of heat absorbed is the power consumption, is established in the equations for this system, and taking the difference between equations (2) and (1) allows the relation in equation (6) to be confirmed.

[Math. 6]

$$P = V \, I = Q_H - Q_C \qquad \cdot \cdot \cdot \ (6)$$

As explained in the equations for this system, in a Peltier module, thermoelectromotive force (= voltage) is generated in proportion to the temperature difference between the heat dissipation surface and the heat absorption surface. As already explained, in the arrangement illustrated in FIG. 2, since the levitation stage 1 is positioned biasedly to the left, no thermal load is applied to the heat absorption fin 6 on the right side, and the heat absorption fin 6 is prone to become too cold. In that case, this means that the heat absorption surface temperature of the Peltier module 7 on the right side will be lower than that of the other Peltier modules 7. In that case, it means that the difference in temperature between the heat dissipation surface and the heat absorption surface of the Peltier module 7 on the right side will be large. As a result, the thermoelectromotive force caused by the Seebeck effect will be larger than those of other Peltier modules 7.

When the same voltage is applied to all the Peltier modules, if the thermoelectromotive force of one Peltier module becomes large, the voltage resulting from the product of the current and the electrical resistance decreases according to the change. This decrease in voltage means that the current flowing through the Peltier module decreases. As a result, if the same voltage is applied to a plurality of Peltier modules and there is a Peltier module whose heat absorption surface temperature drops and whose thermoelectromotive force increases among the Peltier modules, the current flowing through that Peltier module will be lower than those of the others. This reduces the cooling effect of the Peltier module, causing the temperature of the heat absorption surface of the Peltier module to rise. For this reason, applying the same voltage to a plurality of Peltier modules acts to uniform the heat absorption surface temperatures, which means that it acts to uniform the temperatures of the heat absorption fins. Hence, if a current is supplied through a parallel circuit to a plurality of Peltier modules 7 arranged in the direction in which the levitation stage 1 moves, the temperatures of the heat absorption fins 6 in the direction of movement of the levitation stage 1 can be equalized.

If the heat absorption fins 6 have a uniform temperature throughout areas in the direction of movement of the levitation stage 1, the same cooling capacity can be obtained wherever the levitation stage 1 is located. For this reason, the temperature of the levitation stage 1 can be kept constant even in the case where the levitation stage 1 remains in one location for a long period of time and then moves to another location. Furthermore, owing to the control principle described by use of FIG. 1, the temperature of the levitation stage 1 can be kept constant through feedback control, even if the average amount of heat generated by the levitation stage 1 changes.

[Second embodiment]

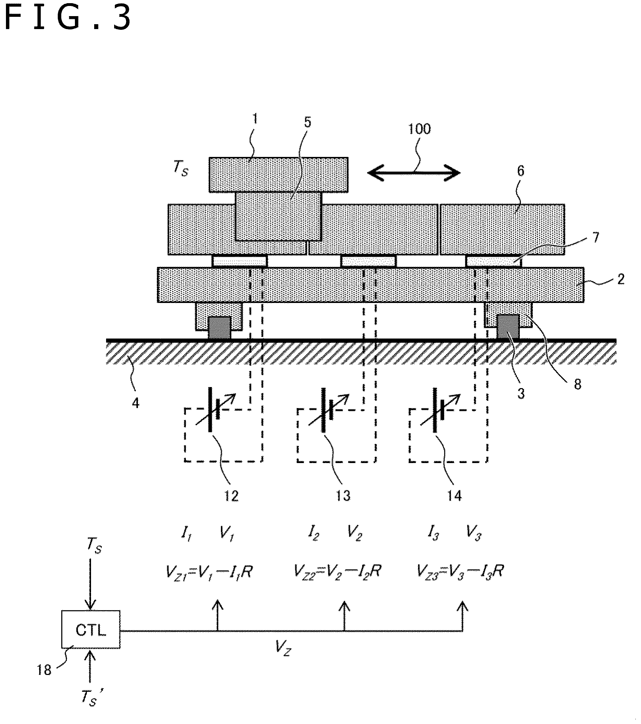

FIG. 3 illustrates the configuration and the system of a stage device in a second embodiment of the present invention. Note that, in the following description, parts with the same functions will be given the same reference numerals and descriptions will be omitted.

The embodiment in FIG. 3 differs from the first embodiment in that individual power supply units 12 through 14 are provided for respective Peltier modules 7 instead of using a single power supply unit to apply the same voltage to a plurality of Peltier modules 7. When there is a power supply unit for each Peltier module on a one-to-one correspondence, the thermoelectromotive force generated in each Peltier module can be identified. That is, when the power supply unit 12 supplies power with a current I1 and a voltage V1, the thermoelectromotive force Vz1 of the Peltier module 7 can be calculated by use of equation (5). The same applies to the power supply units 13 and 14.

Meanwhile, when controlling the temperature of the levitation stage 1 with this configuration, a controller 18 determines the target thermoelectromotive force Vz by looking at the difference between the measured temperature Ts and the target temperature Ts'. This target thermoelectromotive force is given to all Peltier modules 7 as the same target value. Then, each of the power supply units 12 to 14 manipulates the current such that the thermoelectromotive force in the operating state becomes the target value. When such current manipulation is performed, the thermoelectromotive force of all Peltier modules 7 becomes the same, and the temperature can be made uniform with higher accuracy than in the case of the first embodiment. This reduces the temperature change of the levitation stage 1 and further reduces the thermal deformation, thereby improving the positional accuracy.

[Third embodiment]

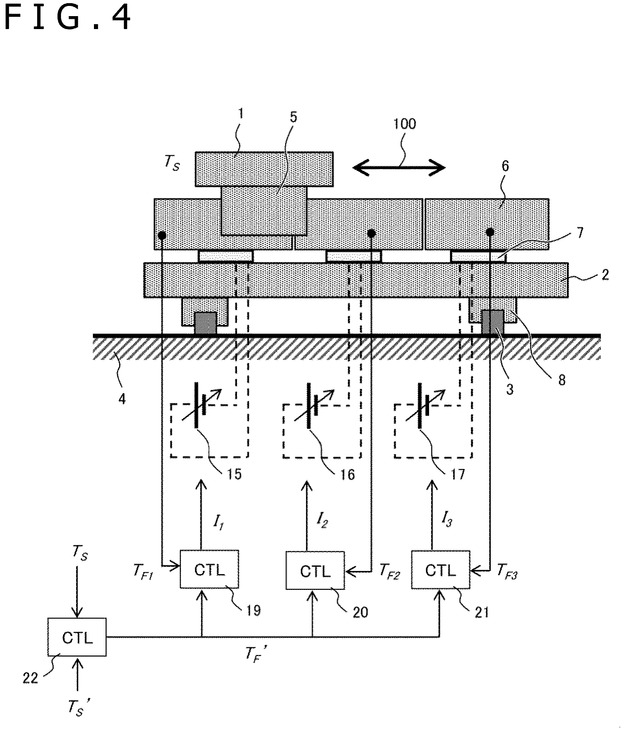

FIG. 4 illustrates the configuration and the system of a stage device in a third embodiment of the present invention. In the present embodiment, the temperature of the heat absorption fin 6 for each Peltier module 7 is measured. The current of each Peltier module 7 is controlled according to the difference between the measured temperature of each heat absorption fin 6 and the target temperature of the heat absorption fin 6. In this case, there are individual controllers 19 through 21 that determine the current of the Peltier modules 7. Moreover, in controlling the temperature of the levitation stage 1, a controller 22 determines the target temperature of the heat absorption fin 6. The individual controllers 19 through 21 are operated with use of the target fin temperature determined by the controller 22. In the controllers 19 through 21, using PID control is also an effective method. The output current of each of power supply units 15 through 17 for the Peltier modules 7 is determined by the controllers 19 through 21, respectively, so that the internal configuration is simplified.

[Fourth embodiment]

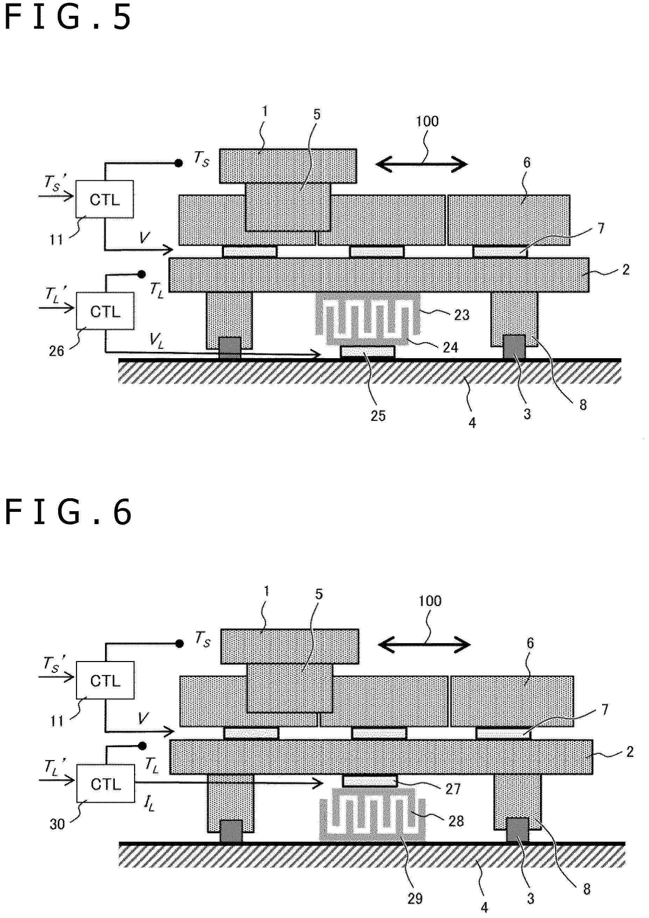

FIG. 5 illustrates the configuration and the system of a stage device in a fourth embodiment of the present invention. In the present embodiment, a cooling system for the lower stage is added to the configuration of the first embodiment. The cooling system for the levitation stage 1 is the same as in the first embodiment, so that a description thereof will be omitted here. Note that the cooling structure for the lower stage illustrated here can also be combined with the cooling system of the levitation stage in the second and third embodiments.

To assist in cooling the lower stage, in the present embodiment, a heat dissipation fin 23 (also referred to as the "third fin") is attached to the bottom surface of the lower stage 2. The heat dissipation fin 23 has a comb-like cross-sectional shape and extends in the direction of movement of the lower stage 2. In addition, a heat absorption fin 24 (also referred to as the "fourth fin") is provided opposite the heat dissipation fin 23, and is attached to the base 4 with a Peltier module 25 (also referred to as the "second Peltier module") sandwiched therebetween. As with the first embodiment, when this stage device operates in a vacuum environment, the base 4 is a vacuum container. Moreover, a plurality of Peltier modules 25 are arranged in the direction of movement of the lower stage 2, and power is supplied via a parallel circuit.

When operating the Peltier module 25 for cooling the lower stage, it is preferable for a controller 26 to recognize the temperature measured by a temperature measuring unit (not illustrated) provided in the lower stage 2, and apply feedback such that the temperature becomes the target temperature for the lower stage, to control the voltage for passing current through the Peltier module 25.

When the temperature of the lower stage 2 is actively controlled as in the present embodiment, the temperature of the lower stage 2 becomes more stable. In the case where there is no active temperature control, when the amount of exhaust heat from the Peltier module 7 for the levitation stage 1 increases, since the temperature of the lower stage 2 rises, the amount of heat transferred from the slide unit 8 to the guide rail 3 is increased to balance the temperatures. On the other hand, when active temperature control is applied to the lower stage 2, the temperature of the lower stage 2 will not fluctuate even if the amount of heat exhausted from the Peltier module 7 fluctuates. As a result, the temperature of the heat dissipation surface of the Peltier module 7 becomes stable, and the amount of heat absorption will simply increase when the current flowing through the Peltier module 7 is increased. If the temperature of the heat dissipation surface of the Peltier module 7 is not stable, the controllability of the amount of heat absorption deteriorates not only because of a change caused by the current passed by the amount of heat absorbed by the Peltier module 7, but also because of the reception of influence by temperature fluctuations on the heat dissipation surface. Hence, actively controlling the temperature of the lower stage 2 to stabilize the temperature improves controllability of the Peltier module 7 for cooling the levitation stage, and contributes to stabilizing the temperature of the levitation stage 1. Furthermore, since the cooling control of the lower stage 2 is solely performed to control the lower stage 2 and make its temperature to the target temperature, there is no need to take into account the operating conditions of the levitation stage 1. As a result, the operations can be carried out as independent control systems, and interference between the two control systems does not occur, so that such phenomena as temperature fluctuations can be prevented.

[Fifth embodiment]

FIG. 6 illustrates the configuration and the system of a stage device in a fifth embodiment of the present invention. The present embodiment also describes an additional cooling system for the lower stage 2, and thus the cooling system for levitation stage to be combined may be any of the first to third embodiments.

In order to assist in cooling the lower stage 2, in the present embodiment, a Peltier module 27 (corresponding to the "second Peltier module") is first attached to the bottom surface of the lower stage 2, and a heat dissipation fin 28 (corresponding to the abovementioned "third fin") is attached to its heat dissipation surface. Further, a heat absorption fin 29 (corresponding to the abovementioned "fourth fin") is attached facing the heat dissipation fin 28, and its rear surface is attached to the base 4. In the present embodiment, since the Peltier module 27 for cooling the lower stage 2 is attached to the moving stage side, there is no need to arrange the Peltier modules in such a manner as to cover the entire moving range of the lower stage. The heat absorption surface of the Peltier module 27 is attached to the main body of the lower stage 2, and absorbs heat from the lower stage 2 to transfer the heat to the heat dissipation fin 28. As a result, the temperature of the heat dissipation fin 28 becomes higher than that of the lower stage 2. Meanwhile, since the heat absorption fin 29 is attached to the base 4, its temperature becomes approximately the same as that of the base 4. The above-described cooling systems have caused radiant heat transfer by keeping the heat absorption fin at a low temperature, but in the cooling of the lower stage in the present embodiment, radiant heat transfer is caused by keeping the heat dissipation fin at a high temperature. In this method, since the Peltier module 27 is attached to the lower stage 2, the positional relation with the Peltier module does not change even when the lower stage 2 moves, and the phenomenon in which the thermal load changes does not occur. For this reason, even when a plurality of Peltier modules are used, the modules do not need to be connected in a parallel circuit and may be connected in a series circuit. When power is supplied in a series circuit, the voltage supplied from the power supply is higher but the current is smaller. Typically, a power supply device can be made smaller as the current is smaller, and thus being operable with a small current has an advantage.

Further, in the present embodiment, in order to prevent the radiated heat from the heat dissipation fin 28 from returning to the lower stage 2, the heat absorption fin 29 is structured to cover up both ends of the heat dissipation fin 28. In the structure illustrated in FIG. 6, the number of fins in the heat absorption fin 29 is set to be one more than that of the heat dissipation fin 28. This configuration makes it possible to prevent heat from returning. Moreover, the surfaces of the heat dissipation fin 28 and the heat absorption fin 29 are preferably subjected to surface treatment to increase the emissivity, but the emissivity of only the rear surface of the heat dissipation fin 28 is preferably reduced.

[Sixth embodiment]

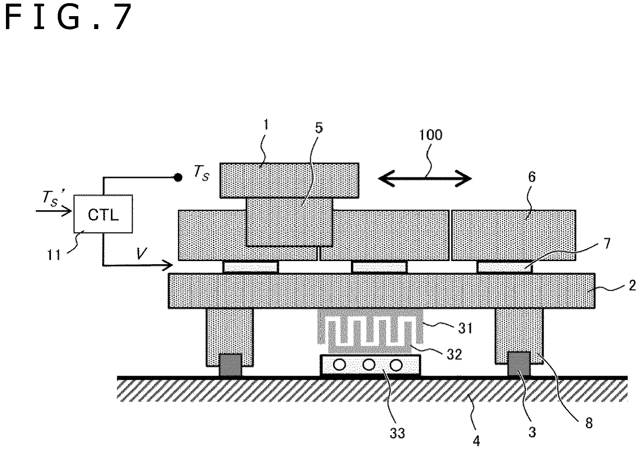

FIG. 7 illustrates the configuration and the system of a stage device in a sixth embodiment of the present invention. In the present embodiment, cooling of the lower stage 2 is assisted by a passive method instead of active control. A heat dissipation fin 31 is attached to the bottom surface of the lower stage 2, and a heat absorption fin 32 is attached opposite to this, with its back surface cooled by a heat sink 33. The heat sink 33 has a coolant which flows inside, which is always maintained at a constant temperature at the heat sink inlet, and which is also operated at a constant flow rate. Hence, the cooling capacity of the heat sink 33 is not actively controlled, and the amount of heat transfer changes over time only due to time variation in the temperature of the heat dissipation fin 31. The lower stage 2 is subjected to a thermal load equal to the sum of the heat generated by the levitation stage 1, power consumption of the Peltier module 7, and heat generated by the lower stage 2. Adding a path for dissipating heat to the heat sink 33 reduces the temperature rise in the lower stage 2 more than dissipating the heat only through heat transfer from the slide unit 8 to the guide rail 3, and also contributes to stabilizing the temperature of the levitation stage 1.

Furthermore, the cooling assistance using the heat sink 33 may be used in combination with the fourth and fifth embodiments.

[Seventh embodiment]

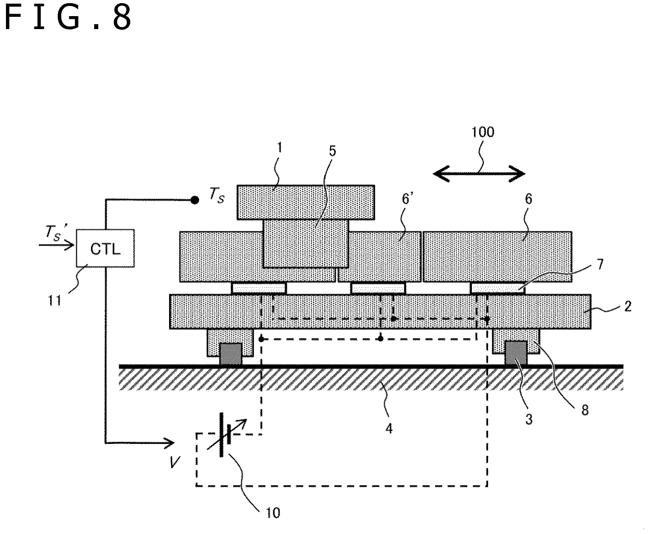

FIG. 8 illustrates the configuration and the system of a stage device in a seventh embodiment of the present invention. The difference between the present example and the first embodiment is that the lengths of the heat absorption fins 6 cooled by respective Peltier modules 7 are different. In the case of a device in which the ratio of the areas where the levitation stage 1 tends to stay is substantially fixed, the thermal load of the Peltier modules can be equalized by increasing the arrangement density of the Peltier modules 7 arranged in areas in which the stay ratio is high. In the embodiment of FIG. 8, it is assumed that the levitation stage 1 will stay in the central region of its range of movement at a high rate. In this case, the thermal load on the central Peltier module 7 will be high. For this reason, the length of a heat absorption fin 6' cooled by the central Peltier module 7 is shortened, and instead, the lengths of the heat absorption fin 6 on the left and right sides are lengthened. If the operating pattern of the levitation stage 1 is fixed and the stay ratio is known in advance, the hardware can be designed accordingly such that the thermal load on the Peltier module 7 is uniform, to make the thermal load uniform and equalize the temperature of the heat absorption fins 6. With such a configuration, the same cooling capacity can be obtained regardless of the location of the levitation stage 1. In addition, although a plurality of Peltier modules 7 are connected in a parallel circuit in FIG. 8, a current can also be supplied by using a series circuit.

**Claims**

1. A stage device comprising:

   a first stage that makes a linear movement;
   a first fin that has a comb-like cross-sectional shape and extends in a direction of the linear movement of the first stage;
   a second stage that has a second fin disposed opposite the first fin and is stationary in relation to the first stage;
   a heat transfer mechanism that transfers heat between the first fin and the second fin while maintaining a non-contact relation between the first fin and the second fin;
   a first Peltier module between the second fin and the second stage, one heat transfer surface of the first Peltier module being in contact with the second fin and the other heat transfer surface being in contact with the second stage; and
   a control unit that controls heat transfer occurring between the first fin at a side of the first stage and the second fin by controlling a temperature of the second fin by the first Peltier module.

2. The stage device according to claim 1,
   wherein

   the second stage includes a plurality of the first Peltier modules which are arranged in a line in a direction of the linear movement of the first stage, and
   the control unit adjusts a current flowing through each of the plurality of first Peltier modules such that the temperature of the second fin installed on the second stage becomes approximately uniform in the direction of the linear movement of the first stage.

3. The stage device according to claim 2,
   wherein
   the control unit performs control in such a manner as to make the temperature of the second fin of the second stage approximately uniform by utilizing a thermoelectromotive force caused by a temperature difference between a heat absorption surface and a heat dissipation surface of each of the plurality of first Peltier modules.

4. The stage device according to claim 3,
   wherein
   the control unit has a parallel circuit for supplying a current to the plurality of first Peltier modules, and performs control in such a manner as to drive each of the plurality of first Peltier modules at approximately a same voltage.

5. The stage device according to claim 2, further comprising:

   a temperature measuring unit that measures a temperature of the first stage, wherein
   the control unit controls a current flowing through the plurality of first Peltier modules and performs control to change the temperature of the second fin of the second stage such that the temperature of the first stage measured by the temperature measurement unit becomes a preset target temperature.

6. The stage device according to claim 1,
   wherein

   the second stage is a lower stage that is movable together with the first stage, and
   directions of movement of the first stage and the second stage are substantially perpendicular to each other to allow the first stage to be two-dimensionally movable.

7. The stage device according to claim 6,
wherein

a stationary portion in relation to the second stage has a third fin having a comb-like cross sectional shape, and the second stage has a fourth fin facing the third fin, and heat transfer between the third fin and the fourth fin facilitates heat transfer of the second stage to the stationary portion.

8. The stage device according to claim 7, further comprising:

a second Peltier module for facilitating heat transfer between the second stage and the stationary portion, wherein the control unit controls the second Peltier module such that a temperature of the second stage becomes a set target temperature.

9. The stage device according to claim 8,
wherein

the first stage is used in a state where the first stage is levitated with respect to the second stage, and the second stage moves in contact with a guide rail provided on the stationary portion.

10. The stage device according to claim 9,
wherein

the first stage is a magnetic levitation stage that is levitated from the second stage by magnetic force, and the first stage is moved linearly by a linear motor, and the linear motor is a moving coil type linear motor.

11. A charged particle beam device comprising:

the stage device according to any one of claims 1 through 10 in a housing maintained to be vacuumed, the stage device being used to position a sample; and
a charged particle beam irradiation unit that irradiates the sample with a charged particle beam.

# FIG.1

# FIG.2

# FIG.3

$$V_{Z1}=V_1-I_1R \quad\quad V_{Z2}=V_2-I_2R \quad\quad V_{Z3}=V_3-I_3R$$

# F I G . 4

# F I G . 5

# F I G . 6

F I G . 7

# FIG.8

Europäisches
Patentamt

European
Patent Office

Office européen
des brevets

# EUROPEAN SEARCH REPORT

**Application Number**

EP 25 16 8624

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2019 067546 A (HITACHI HIGH TECH CORP) 25 April 2019 (2019-04-25) * abstract * * paragraph [0001] - paragraph [0058] * * figure 1 * ----- | 1-11 | INV. H01J37/20 H01J37/28 F25B21/02 |
| A | US 3 171 956 A (COLEMAN JOHN W ET AL) 2 March 1965 (1965-03-02) * abstract * * column 1 - column 18 * * figure 1 * ----- | 1-11 | |

**TECHNICAL FIELDS SEARCHED (IPC)**

H01J
F25B

The present search report has been drawn up for all claims

| Place of search | Date of completion of the search | Examiner |
|---|---|---|
| Munich | 27 September 2025 | Bridi, Dorian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 16 8624

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2025

| Patent document cited in search report | Publication date | Patent family member(s) | Publication date |
|---|---|---|---|
| JP 2019067546 A | 25-04-2019 | NONE | |
| US 3171956 A | 02-03-1965 | NONE | |

EPO FORM P0459

For more details about this annex : see Official Journal of the European Patent Office, No. 12/82

**EP 4 654 243 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003058258 A

- JP 2006351741 A